(19) Europäisches Patentamt / European Patent Office / Office européen des brevets

(11) **EP 4 717 717 A1**

(12) **EUROPEAN PATENT APPLICATION**
published in accordance with Art. 153(4) EPC

(43) Date of publication:
01.04.2026 Bulletin 2026/14

(21) Application number: 24941984.7

(22) Date of filing: 03.12.2024

(51) International Patent Classification (IPC):
$C08F\ 255/02^{(2006.01)}$    $C08F\ 230/08^{(2006.01)}$
$C08F\ 210/16^{(2006.01)}$    $C08L\ 51/06^{(2006.01)}$
$C08J\ 5/18^{(2006.01)}$    $H10F\ 19/80^{(2025.01)}$

(52) Cooperative Patent Classification (CPC):
C08F 210/16; C08F 230/08; C08F 255/02;
C08J 5/18; C08L 51/06; H10F 19/80; Y02E 10/50

(86) International application number:
PCT/KR2024/019550

(87) International publication number:
WO 2025/249676 (04.12.2025 Gazette 2025/49)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 31.05.2024 KR 20240071568

(71) Applicant: LG Chem, Ltd.
Seoul 07336 (KR)

(72) Inventors:
• LEE, Hye Ji
Daejeon 34122 (KR)

• HAN, Sang Wook
Daejeon 34122 (KR)
• LEE, Eun Jung
Daejeon 34122 (KR)
• KWAK, Soo Young
Daejeon 34122 (KR)
• LEE, Young Woo
Daejeon 34122 (KR)
• JUN, Jung Ho
Daejeon 34122 (KR)

(74) Representative: Vossius & Partner
Patentanwälte Rechtsanwälte mbB
Siebertstraße 3
81675 München (DE)

(54) **POLYOLEFIN COMPOSITION**

(57) The present invention relates to a polyolefin composition wherein the polyolefin composition of the present invention includes a modified polyolefin containing a vinyl silane group, and may thus improve the degree of crosslinking, and when the polyolefin composition of the present invention is used for manufacturing an encapsulant film, improved degree of crosslinking may be achieved while maintaining optical properties and insulating properties.

EP 4 717 717 A1

**Description**

## TECHNICAL FIELD

### Cross-reference to Related Applications

This application claims the benefit of Korean Patent Application No. 10-2024-0071568, filed on May 31, 2024, in the Korean Intellectual Property Office, the contents of which are incorporated herein by reference.

### Technical Field

The present invention relates to a polyolefin composition.

## BACKGROUND ART

Polyolefin elastomers (POE) provide superior insulation and moisture barrier properties compared to ethylene vinyl acetate (EVA), and thus are gaining popularity as encapsulants for solar cells.
However, POE encapsulants have a lower degree of crosslinking compared to EVA, which may lead to issues such as bubble formation and reduced bonding stability during module manufacturing. In addition, for EVA-POE-EVA three-layer encapsulants, which are rapidly gaining market share, issues caused by low crosslinking degree, such as bubble formation and interlayer delamination due to differences in crosslinking rate and degree between EVA and POE, have become more prominent.
Therefore, to address these issues, efforts are being made to improve module manufacturing stability by enhancing the crosslinking degree of POE encapsulants.

## DISCLOSURE OF THE INVENTION

## TECHNICAL PROBLEM

An aspect of the present invention provides a polyolefin composition exhibiting improved crosslinking degree while maintaining optical properties and insulating properties.

## TECHNICAL SOLUTION

1. According to an aspect of the present invention, there is provided a polyolefin composition including a modified polyolefin containing a vinyl silane group.
2. The present invention provides the polyolefin composition according to 1, wherein the polyolefin composition includes terminal double bonds at a content of 0.001 to 1 per 1,000 total carbon atoms, as detected at 5.7 to 6.3 ppm of peaks originating from a modified portion in the modified polyolefin, when the modified polyolefin is immersed in acetone at 60°C for 12 hours, washed, and subsequently dissolved in TCE-$d_2$ solvent, and then subjected to $^1$H NMR (373K) analysis.
3. The present invention provides the polyolefin composition according to 1 or 2, wherein the vinyl silane group is derived from a silane compound containing two or more vinyl groups.
4. The present invention provides the polyolefin composition according to any one of 1 to 3, wherein the silane compound is selected from the group consisting of tris(vinyldimethylsiloxy)methylsilane, tris(vinyldimethylsiloxy) phenylsilane, 1,3,5-trivinyl-1,1,3,5,5-pentamethyltrisiloxane, 2,4,6-trimethyl-2,4,6-trivinylcyclotrisiloxane, tetravinylsilane, and 1,3-divinyltetramethyldisiloxane.
5. The present invention provides the polyolefin composition according to any one of 1 to 4, wherein the polyolefin is a copolymer of ethylene and an alpha-olefin comonomer.
6. The present invention provides the polyolefin composition according to any one of 1 to 5, wherein the alpha-olefin comonomer is an alpha-olefin comonomer of 3 to 12 carbon atoms.
7. The present invention provides the polyolefin composition according to any one of 1 to 6, wherein the alpha-olefin comonomer includes at least one selected from the group consisting of 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alphamethylstyrene, divinylbenzene, and 3-chloromethylstyrene.

8. According to another aspect of the present invention, there is provided a composition for an encapsulant film including the polyolefin composition according to any one of 1 to 7.

9. According to another aspect of the present invention, there is provided an encapsulant film formed with the composition for an encapsulant film of 8.

10. According to another aspect of the present invention, there is provided a solar cell module including the encapsulant film of 9.

## ADVANTAGEOUS EFFECTS

A polyolefin composition of the present invention includes a modified polyolefin containing a vinyl silane group, and may thus exhibit improved degree of crosslinking.

When manufacturing an encapsulant film using the polyolefin composition of the present invention as described above, improved degree of crosslinking may be achieved while maintaining optical properties and insulating properties, thereby enhancing module manufacturing stability.

## MODE FOR CARRYING OUT THE INVENTION

Hereinafter, the present invention will be described in more detail to assist the understanding of the present invention.

The present invention provides a polyolefin composition including a modified polyolefin containing a vinyl silane group.

Due to the vinyl silane group contained in the modified polyolefin, when a crosslinking agent, a crosslinking auxiliary agent, and the like are added and subjected to reactions to manufacture an encapsulant film or the like, a higher crosslinking reaction may be induced, and thus a significant crosslinking degree improvement effect may be achieved.

The modified polyolefin may include terminal double bonds at a content of 0.001 to 1 per 1,000 total carbon atoms, as detected at 5.7 to 6.3 ppm of peaks originating from a modified portion in the modified polyolefin, when the modified polyolefin was immersed in acetone at 60°C for 12 hours, washed, and subsequently dissolved in TCE-$d_2$ solvent, and then subjected to $^1$H NMR (373K) analysis. The detected terminal double bonds may be derived from the vinyl silane group.

When the modified polyolefin is subjected to NMR analysis and the content of terminal double bonds detected at 5.7 to 6.3 ppm is measured, some of the terminal double bonds contained in the existing polyolefin (i.e., unmodified polyolefin) and the content of terminal double bonds originating from a modified portion may all be included. Through hydrogen peaks originating from two terminal double bonds detected in a range that does not overlap the range of 5.7 to 6.3 ppm among the terminal double bonds originating from the unmodified portion in the modified polyolefin, a hydrogen peak of one terminal double bond detected at 5.7 to 6.3 ppm may be calculated. Therefore, by performing NMR analysis on the modified polyolefin and subtracting the hydrogen peak of one terminal double bond originating from the unmodified portion from the terminal double bond content detected at 5.7 to 6.3 ppm, the content of terminal double bonds detected at 5.7 to 6.3 ppm from the ones originating from the modified portion in the modified polyolefin may be obtained.

More specifically, in the NMR analysis, the content of terminal double bonds detected at 5.7 to 6.3 ppm of peaks originating from a modified portion in the modified polyolefin may be 0.001 or more, 0.0015 or more, 0.002 or more, 0.0025 or more, 0.003 or more, 0.0035 or more, 0.004 or more, 0.0045 or more, 0.005 or more, per 1000 total carbon atoms, and may also be 1 or less, 0.98 or less, 0.96 or less, 0.94 or less, 0.92 or less, 0.9 or less, 0.88 or less, 0.86 or less, or 0.84 or less, per 1000 total carbon atoms. By introducing terminal double bonds that play a leading role in crosslinking reactions into the modified polyolefin, the degree of crosslinking may be improved in a subsequent crosslinking reaction using a crosslinking agent, a crosslinking auxiliary agent, and the like. Therefore, the polyolefin composition of the present invention includes a modified polyolefin including terminal double bonds in the above range, and may thus exhibit a significantly improved degree of crosslinking.

The vinyl silane group may be derived from a silane compound. The modified polyolefin may be a typical, general polyolefin modified through a chemical reaction (e.g., grafting, polymerization, or the like) with a silane compound so as to include a vinyl silane group. In this case, the silane compound may include two or more vinyl groups, and by including two or more vinyl groups, at least one unreacted vinyl group may remain even after the chemical reaction with the polyolefin.

For example, the modified polyolefin of the present invention may be prepared by grafting a silane compound onto a polyolefin backbone. The polyolefin may be a polyolefin in which a compound other than ethylene and alpha-olefin is not included or not polymerized.

When grafting a silane compound onto the polyolefin backbone to prepare the modified polyolefin, a crosslinking agent may be added together and subjected to reactions. When a crosslinking agent is added, the crosslinking agent serves to initiate a grafting reaction of a silane compound, thereby allowing the silane compound to be grafted onto the polyolefin backbone more effectively. The crosslinking agent may be, for example, one or two or more selected from the group consisting of an organic peroxide, a hydroperoxide, and an azo compound. Specifically, the crosslinking agent may be at least one selected from the group consisting of compounds such as 2,5-bis(t-butylperoxy)-2.5-dimethylhexane, t-buphylcumyl peroxide, di-t-butyl peroxide, di-cumyl peroxide, 2,5-dimethyl-2,5-di(t-butylperoxy)hexane, 2,5-dimethyl-2,5-di(t-butylperoxy)-3-hexyne, bis-3,5,5-trimethylhexanoyl peroxide, octanoyl peroxide, benzoyl peroxide, o-methylbenzoyl peroxide, 2,4-dichlorobenzoyl peroxide, diacyl peroxides; t-butylperoxy isobutyrate, t-butylperoxy acetate, t-butylperoxy-2-ethylhexylcarbonate (TBEC), t-butylperoxy-2-ethylhexanoate, t-butylperoxy pivalate, t-butylperoxy octoate, t-butylperoxyisopropyl carbonate, t-butylperoxybenzoate, dit-butylperoxyphthalate, 2,5-dimethyl-2,5-di(benzoylperoxy)hexane, and 2,5-dimethyl-2,5-di(benzoylperoxy)-3-hexyne. More specifically, the crosslinking agent may be 2,5-bis(t-butylperoxy)-2.5-dimethylhexane, and may be prepared used or may be purchased and used as a commercially available product (e.g., Luperox 101).

The silane compound may contain two or more vinyl groups. By grafting a silane compound containing two or more vinyl groups onto the polyolefin backbone as described above, vinyl groups may remain in the modified polyolefin obtained after the silane compound is grafted. When applied to an encapsulant film or the like, due to the vinyl groups remaining as described above, the effect of improving the degree of crosslinking may be obtained.

In addition, the silane compound may contain a methyl group. When the silane compound contains a methyl group, the modified polyolefin may have improved stability.

The silane compound may be selected from the group consisting of, for example, tris(vinyldimethylsiloxy) methylsilane, tris(vinyldimethylsiloxy)phenylsilane, 1,3,5-trivinyl-1,1,3,5,5-pentamethyltrisiloxane, 2,4,6-trimethyl-2,4,6-trivinylcyclotrisiloxane, tetravinylsilane, and 1,3-divinyltetramethyldisiloxane.

In addition, the modified polyolefin may include the methyl group at a content of 15 or less per 1,000 total carbon atoms, as detected at 0.0 to 0.4 ppm of peaks originating from a modified portion in the modified polyolefin, when the modified polyolefin was immersed in acetone at 60°C for 12 hours, washed, and subsequently dissolved in TCE-$d_2$ solvent, and then subjected to $^1$H NMR (373K) analysis.

As such, the modified polyolefin may include a methyl silane group, and the detected methyl group may be derived from the methyl silane group.

When the silane compound subjected to chemical reactions to introduce a vinyl silane group to the modified polyolefin includes a methyl silane group, the modified polyolefin may include a methyl silane group.

More specifically, in the NMR analysis, the content of the methyl group detected at 0.0 to 0.4 ppm may be 0 or more, 0.03 or more, 0.05 or more, 0.07 or more, 0.09 or more, 0.1 or more, 0.2 or more, 0.3 or more, 0.4 or more, 0.5 or more, 0.6 or more, 0.7 or more, 0.8 or more, 0.9 or more, 1 or more, 1.5 or more, 2 or more, 2.5 or more, 3 or more, per 1,000 total carbon atoms, and may also be 15 or less, 14 or less, 13 or less, 12 or less, or 11 or less, per 1,000 total carbon atoms. Vinyltrimethoxysilane (VTMS), which is commonly used in typical reaction extrusion, contains methoxy groups, and may thus undergo side reactions such as hydrolysis in the presence of moisture, resulting in poor stability whereas the modified polyolefin contains methyl groups in the above range, and may not undergo such side reactions, resulting in improved stability.

The polyolefin may be a copolymer of ethylene and an alpha-olefin comonomer. The modified olefin of the present invention may also be based on the polyolefin as described above.

The alpha-olefin comonomer may be specifically an alpha-olefin comonomer of 3 to 12 carbon atoms, and more specifically an alpha-olefin comonomer of 4 to 8 carbon atoms. For example, the alpha-olefin comonomer may be at least one selected from the group consisting of 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alphamethylstyrene, divinylbenzene, and 3-chloromethylstyrene, and for more specific examples, may be 1-butene, 1-octene, or a combination thereof.

The polyolefin composition of the present invention may include only the modified polyolefin, or may include an unmodified polyolefin together with the modified polyolefin. The unmodified polyolefin may be the above described copolymer of ethylene and an alpha-olefin comonomer.

When the polyolefin composition of the present invention includes a non-modified polyolefin together with the modified polyolefin, the modified polyolefin may be included in an amount of 1 wt% or more and 60 wt% or less with respect to a total weight of the entire polyolefin composition. More specifically, the modified polyolefin may be included in an amount of 1 wt% or more, 2 wt% or more, 3 wt% or more, 4 wt% or more, or 5 wt% or more, and may also be included in an amount of 60 wt% or less, 59 wt% or less, 58 wt% or less, 57 wt% or less, 56 wt% or less, 55 wt% or less, 54 wt% or less, 53 wt% or less, 52 wt% or less, 51 wt% or less, or 50 wt% or less. When the modified polyolefin is included in an amount less than the above range, the effect of improving the degree of crosslinking may be insignificant.

In addition, the present invention provides a composition for an encapsulant film including the above-described polyolefin composition.

The composition for an encapsulant film may further include at least one selected from the group consisting of a crosslinking agent, a crosslinking auxiliary agent, a silane coupling agent, a light stabilizer, a UV absorber, and a thermal stabilizer.

The crosslinking agent may improve the heat resistance/durability of an encapsulating sheet promoting the formation of crosslinking bonds.

The crosslinking agent may be, for example, one or two or more selected from the group consisting of an organic peroxide, a hydroperoxide, and an azo compound.

Specifically, the crosslinking agent may be at least one selected from the group consisting of dialkyl peroxides such as t-buphylcumyl peroxide, di-t-butyl peroxide, di-cumyl peroxide, 2,5-dimethyl-2,5-di(t-butylperoxy)hexane, and 2,5-dimethyl-2,5-di(t-butylperoxy)-3-hexyne; hydroperoxides such as cumene hydroperoxide, diisopropyl benzene hydroperoxide, 2,5-dimethyl-2,5-di(hydroperoxy)hexane, and t-butyl hydroperoxide; diacyl peroxides such as bis-3,5,5-trimethylhexanoyl peroxide, octanoyl peroxide, benzoyl peroxide, o-methylbenzoyl peroxide, and 2,4-dichlorobenzoyl peroxide; peroxy esters such as t-butylperoxy isobutyrate, t-butylperoxy acetate, t-butylperoxy-2-ethylhexylcarbonate (TBEC), t-butylperoxy-2-ethylhexanoate, t-butylperoxy pivalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, and 2,5-dimethyl-2,5-di(benzoylperoxy)-3-hexyne; ketone peroxides such as methylethyl ketone peroxide and cyclohexanone peroxide, lauryl peroxide, and azo compounds such as azobisisobutyronitrile and azobis(2,4-dimethylvaleronitrile), but is not limited thereto.

The organic peroxide may be an organic peroxide having a one-hour half-life temperature of 120 to 135°C, for example, 120 to 130°C, 120 to 125°C, preferably 121°C. The "one-hour half-life temperature" indicates a temperature at which the half-life of the crosslinking agent reaches 1 hour. According to the one-hour half-life temperature, the temperature at which radical initiation reaction is efficiently performed may become different. Therefore, in case of using the organic peroxide having the one-hour half-life temperature in the above-described range as a crosslinking agent, radical initiation reaction, that is, crosslinking reaction in a lamination process temperature for manufacturing an optoelectronic device may be effectively performed.

The crosslinking agent may be included in an amount of 0.01 part by weight or more, and 5 parts by weight or less with respect to 100 parts by weight of the polyolefin composition. Specifically, for example, the crosslinking agent may be included in an amount of 0.01 parts by weight or more, 0.02 parts by weight or more, 0.04 parts by weight or more, 0.06 parts by weight or more, or 0.08 parts by weight or more, and may also be included in an amount of 5 parts by weight or less, 4 parts by weight or less, 3 parts by weight or less, or 2 parts by weight or less. When the crosslinking agent is included in an amount less than 0.01 parts by weight, the effect of improving the degree of crosslinking may be insignificant, and when the amount is greater than 5 parts by weight, the moldability of final products such as an encapsulant film and an encapsulant sheet may be reduced, which may cause limitations in process, and may affect the physical properties of an encapsulant.

In addition, the composition for an encapsulant film may include a crosslinking auxiliary agent in addition to the crosslinking agent. By including the crosslinking auxiliary agent in the composition for an encapsulant film, the crosslinking degree in the composition for a film by the crosslinking agent described above may be increased, and accordingly, the crosslinking degree and stability in a final product may be improved even further.

The crosslinking auxiliary agent may use various crosslinking auxiliary agents known in the art, for example, a compound containing at least one unsaturated group such as an allyl group and a (meth)acryloxy group may be used.

The compound containing an allyl group may include, for example, a polyallyl compound such as triallyl isocyanurate (TAIC), triallyl cyanurate, diallyl phthalate, diallyl fumarate, and diallyl maleate, and the compound containing a (meth)acryloxy group may include, for example, a poly(meth)acryloxy compound such as ethylene glycol diacrylate, ethylene glycol dimethacrylate, and trimethylolpropane trimethacryate, but the present invention is not particularly limited thereto.

The crosslinking auxiliary agent may be included in an amount of 0.1 parts by weight or more and 1 part by weight or less, with respect to 100 parts by weight of the polyolefin composition. Specifically, for example, the crosslinking auxiliary agent may be included in an amount of 0.1 parts by weight or more, 0.2 parts by weight or more, 0.3 parts by weight or more, or 0.4 parts by weight or more, and may also be included in an amount of 1 part by weight or less, 0.9 parts by weight or less, 0.8 parts by weight or less, 0.7 parts by weight or less, or 0.6 parts by weight or less. When the crosslinking auxiliary agent is included in an amount less than 0.01 parts by weight, the effect of improving the degree of crosslinking may be insignificant, and when the amount is greater than 1 parts by weight, the physical properties of a final product such as an encapsulant film are affected, and production costs may increase.

In addition, the composition for an encapsulant film may include a silane coupling agent.

The silane coupling agent may be, for example, at least one selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO).

The silane coupling agent may be included in an amount of 0.1 parts by weight or more and 0.5 part by weight or less, with respect to 100 parts by weight of the polyolefin composition. Specifically, for example, the silane coupling agent may be included in an amount of 0.1 parts by weight or more, 0.12 parts by weight or more, 0.14 parts by weight or more, 0.16 parts by weight or more, or 0.18 parts by weight or more, and may also be included in an amount of 0.5 parts by weight or less, 0.45 parts by weight or less, 0.4 parts by weight or less, 0.3 parts by weight or less, or 0.35 parts by weight or less. When the silane coupling agent is used in an amount less than 0.1 parts by weight, the adhesion to glass during the manufacture of a solar module is poor, which makes the penetration of moisture easy, and thus the long-term performance of the module may not be guaranteed, and when the amount used is greater than 0.5 parts by weight, the yellow index (Y.I) increases, which is not desirable.

The light stabilizer may play a role in preventing photooxidation by capturing an active species of the photothermal initiation of a resin, depending on the application of the composition. The type of the light stabilizer that may be used is not particularly limited, and for example, a known compound such as a hindered amine compound or a hindered piperidine compound may be used.

The UV absorber may play a role in preventing the active species of the photothermal initiation of the resin composition from being excited by absorbing ultraviolet rays from sunlight or the like and converting them into harmless heat energy within the molecule, depending on the application of the composition. The specific type of the UV absorber that may be used is not particularly limited, and for example, one or a mixture of two or more types of inorganic UV absorbers of benzophenone-based, benzotriazole-based, acrylonitrile-based, metal complex-based, hindered amine-based, ultrafine titanium oxide, or ultrafine zinc oxide may be used.

In addition, examples of the thermal stabilizer include phosphorus-based thermal stabilizers such as tris(2,4-di-tert-butylphenyl)phosphite, bis[2,4-bis(1,1-dimethylethyl)-6-methylphenyl]ethyl ester phosphorous acid, tetrakis(2,4-di-tert-butylphenyl) [1,1-biphenyl]-4,4'-diylbisphosphonate, and bis(2,4-di-tert-butylphenyl)pentaerythritol diphosphite; lactone-based thermal stabilizers such as a reaction product of 8-hydroxy-5,7-di-tert-butyl-furan-2-one and o-xylene, and one or more thereof may be used.

The contents of the light stabilizer, UV absorber, and/or thermal stabilizer are not particularly limited. That is, the content of the additive may be appropriately selected in consideration of the purpose of the resin composition, the shape or density of the additive, etc., and may be appropriately adjusted within a range of 0.01 to 5 parts by weight with respect to 100 parts by weight of the total solid content of the composition for an encapsulant film.

In addition, the present invention provides an encapsulant film formed with the above-described composition for an encapsulant film.

The encapsulant film of the present invention may be manufactured by molding the aforementioned composition for an encapsulant film into a film or sheet shape. The molding method is not particularly limited, and for example, the encapsulant film may be manufactured by forming a sheet or film using a common process such as a T-die process or extrusion. For example, the manufacture of the encapsulant film may be performed as an in-situ process using a device in which the preparation of a modified resin composition using the composition for an encapsulant film and the process of forming a film or sheet, are connected to each other.

The thickness of the encapsulant film may be adjusted to about 10 to 2,000 $\mu$m, or about 100 to 1,250 $\mu$m, considering the support efficiency and breakage possibility of the element in the optoelectronic device, the weight reduction or workability of the device, and may be changed depending on the specific use.

In addition, the present invention provides a solar cell module including the encapsulant film. In the present invention, the solar cell module may have a configuration in which the gaps between the cells of the solar cell, arranged in series or in parallel are filled with the encapsulant film of the present invention, a glass surface is positioned on the side where sunlight strikes, and the back surface is protected with a back sheet, and various types and shapes of solar cell modules manufactured including the encapsulant film in the relevant technical field may all be applied to the present invention.

The glass surface may use tempered glass to protect the solar cell from external impact and prevent damage, and low iron tempered glass with a low iron content may be used to prevent reflection of sunlight and increase the transmittance of sunlight.

The back sheet is a weather-resistant film that protects the back surface of the solar cell module from the outside, and includes, for example, a fluorine-based resin sheet, a metal plate or metal foil of aluminum or the like, a cyclic olefin-based resin sheet, a polycarbonate-based resin sheet, a poly(meth)acrylic-based resin sheet, a polyamide-based resin sheet, a polyester-based resin sheet, a composite sheet in which a weather-resistant film and a barrier film are laminated or the like.

In addition, the solar cell module of the present invention may be manufactured without limitation according to a method known in the art, except for including the aforementioned encapsulant film.

The solar cell module of the present invention is manufactured using an encapsulant film with minimized creep phenomenon, and thus hardly undergoes deformation even if used for a long time and in an extreme environment (for example, maintaining durability even under conditions of a temperature of 85°C and a humidity of 85%), and has excellent durability because a delamination phenomenon is minimized, and may greatly suppress the occurrence of output reduction problems or the like.

## Examples

Hereinafter, the present invention will be described in more detail referring to Examples. However, Examples are intended to illustrate the present invention, and the scope of the present invention is not limited thereto.

**[Preparation of modified polyolefin]**

**Preparation Example 1**

A mixture of 0.1012 mol of tris(vinyldimethylsiloxy)methylsilane as a reagent (silane compound) and 0.0021 mols of peroxide (Luperox 101) was injected into 1 kg of ethylene/1-butene copolymer (EBR; density: 0.877 g/cm$^3$, melt index (190°C, 2.16 kg load): 14 g/10 min) at a constant rate through a syringe pump to perform reaction extrusion, thereby preparing a modified polyolefin. In this case, a twin-screw extruder used for reaction extrusion was operated at a temperature range of 100 to 220°C, with a screw feeder speed of 9.82 rpm and an extruder screw speed of 200 rpm.

**Preparation Examples 2 to 8**

A modified polyolefin was prepared in the same manner as in Preparation Example 1, except that the copolymer type, reagent type and content, and peroxide content were changed as shown in Table 1 below.

Preparation Example 6 used an ethylene/1-octene copolymer (EOR) with a density of 0.876 g/cm$^3$ and a melt index (190°C, 2.16 kg load) of 13 g/10 min as a copolymer.

[Table 1]

|  | Copolymer | Type of reagent | Content of reagent | Content of peroxide |
|---|---|---|---|---|
| Preparation Example 1 | EBR | Tris(vinyldimethylsiloxy)methylsilane | 0.1012 moles | 0.0021 moles |
| Preparation Example 2 | EBR |  | 0.3373 moles | 0.007 moles |
| Preparation Example 3 | EBR | Tris(vinyldimethylsiloxy)phenylsilane | 0.1012 moles | 0.0021 mole |
| Preparation Example 4 | EBR | 1,3,5-trivinyl-1,1,3,5,5-pentamethyltrisiloxane | 0.1012 moles | 0.0021 moles |
| Preparation Example 5 | EBR | 2,4,6-trimethyl-2,4,6-trivinylcyclotrisiloxane | 0.1012 moles | 0.0021 moles |
| Preparation Example 6 | EOR |  | 0.1012 moles | 0.0021 moles |
| Preparation Example 7 | EBR | Tetravinylsilane | 0.1012 moles | 0.0021 moles |
| Preparation Example 8 | EBR | 1,3-divinyltetramethyldisiloxane | 0.3373 moles | 0.007 moles |

**Comparative Preparation Example 1**

With respect to 100 parts be weight of ethylene/1-butene copolymer (EBR; density: 0.877 g/cm$^3$, melt index (190°C, 2.16 kg load): 14 g/10 min), a mixture of 5.000 parts by weight of vinyltrimethoxysilane (VTMS) as a reagent (silane compound) and 0.2 parts by weight of peroxide (Luperox 101) was injected at a constant rate through a syringe pump to perform reaction extrusion, thereby preparing a modified polyolefin. In this case, a twin-screw extruder used for reaction extrusion was operated at a temperature range of 100 to 220°C, with a screw feeder speed of 9.82 rpm and an extruder screw speed of 200 rpm.

**[Preparation of polyolefin composition and encapsulant film]**

## Examples 1 to 8

Each of the modified polyolefins of Preparation Examples 1 to 8 was used as a polyolefin composition, and an encapsulant film was manufactured using the following method.

The Haake Modular Torque Viscometer was set at a bowl temperature of 40°C. After the polyolefin composition was added to the bowl, 1.0 part by weight of a crosslinking agent (TBEC), 0.5 part by weight of a crosslinking auxiliary agent (TAIC), and 0.2 part by weight of a silane coupling agent (MEMO) were added with respect to 100 parts by weight of the polyolefin composition using an electric pipette. While stirring the mixture at 40°C and 40 rpm, the change in torque value over time was observed, and the impregnation was terminated when the torque value increased rapidly. Thereafter, the impregnated sample was press-molded into a sheet-shaped encapsulant film with an average thickness of 0.5 mm at a low temperature (compressor barrel temperature of 90 to 100°C) enough to prevent high temperature cross-linking.

## Examples 9 to 14

The modified polyolefins of Preparation Examples 3 and 5 and ethylene/1-butene copolymer (EBR; density: 0.877 g/cm$^3$, melt index (190°C, 2.16 kg load) 14 g/10 min) were mixed as shown in Table 2 below and used as polyolefin compositions.

An encapsulant film was manufactured in the same manner as in Examples 1 to 8, except that the mixture as shown in Table 2 below was used as a polyolefin composition.

[Table 2]

|  | Modified polyolefin (wt%) | EBR (wt%) |
|---|---|---|
| Example 9 | Preparation Example 3 (5 wt%) | 95 wt% |
| Example 10 | Preparation Example 3 (30 wt%) | 70 wt% |
| Example 11 | Preparation Example 3 (50 wt%) | 50 wt% |
| Example 12 | Preparation Example 5 (5 wt%) | 95 wt% |
| Example 13 | Preparation Example 5 (30 wt%) | 70 wt% |
| Example 14 | Preparation Example 5 (50 wt%) | 50 wt% |

## Comparative Example 1

An ethylene/1-butene copolymer (EBR; density: 0.877 g/cm$^3$, melt index (190°C, 2.16 kg load) 14 g/10 min) was used as a polyolefin composition.

An encapsulant film was manufactured in the same manner as in Examples 1 to 8, except that the polyolefin composition was changed.

## Comparative Example 2

The modified polyolefin of Comparative Preparation Example 1 was used as a polyolefin composition.

An encapsulant film was manufactured in the same manner as in Examples 1 to 8, except that the polyolefin composition was changed.

## Experimental Example 1

The physical properties of the polyolefin compositions of Examples 1 to 14 and Comparative Examples 1 and 2 were evaluated according to the methods below, and are shown in Table 3.

1) Density

Measurement was conducted by ASTM D-792.

2) Melt Index (MI)

Measurement was conducted by ASTM D-1238 (Condition E, 190°C, 2.16 kg load).

3) Melt flow ratio (MFR)

Calculated as the ratio of the melt index measured by ASTM D-1238 (Condition E, 190°C, 10 kg load) to the melt index measured by ASTM D-1238 (Condition E, 190°C, 2.16 kg load) ($MI_{10}/MI_{2.16}$).

[Table 3]

|  | Density (g/cc) | MI (dg/min) | MFR (dg/min) |
|---|---|---|---|
| Example 1 | 0.8800 | 7.2 | 8.9 |
| Example 2 | 0.8828 | 2.4 | 13.0 |
| Example 3 | 0.8786 | 10.6 | 7.7 |
| Example 4 | 0.8802 | 9.1 | 7.9 |
| Example 5 | 0.8792 | 3.9 | 9.8 |
| Example 6 | 0.8765 | 4.3 | 10.1 |
| Example 7 | 0.8790 | 9.2 | 8.1 |
| Example 8 | 0.8778 | 4.3 | 10.9 |
| Example 9 | 0.8771 | 13.7 | 6.8 |
| Example 10 | 0.8776 | 13.0 | 7.0 |
| Example 11 | 0.8777 | 12.4 | 7.4 |
| Example 12 | 0.8773 | 13.3 | 7.0 |
| Example 13 | 0.8777 | 11.0 | 7.7 |
| Example 14 | 0.8780 | 9.1 | 8.5 |
| Comparative Example 1 | 0.8770 | 14.0 | 6.8 |
| Comparative Example 2 | 0.8828 | 9.6 | 8.2 |

**Experimental Example 2**

NMR was measured for the polyolefin compositions of Examples 1 to 14 and Comparative Examples 1 and 2 according to the following method, and analysis results are shown in Table 4.

The polyolefin composition was immersed in acetone at 60°C for 12 hours, and then, after the removal of acetone, washed with clean acetone four times to perform a pretreatment. The pretreated polyolefin composition was dissolved in a TCE-$d_2$ solvent and subjected to $^1$H NMR (373K) analysis.

From the NMR analysis results, peaks of terminal double bonds detected at 5.7 to 6.3 ppm include some peaks of the terminal double bonds that were already present in the polyolefin before modification (i.e., terminal double bonds originating from an unmodified portion). Through hydrogen peaks originating from two terminal double bonds detected in a range that does not overlap the range of 5.7 to 6.3 ppm among the terminal double bonds originating from the unmodified portion, a hydrogen peak of one terminal double bond detected at 5.7 to 6.3 ppm may be calculated. Therefore, by performing NMR analysis on the modified polyolefin and subtracting the hydrogen peak of one terminal double bond originating from the unmodified portion from the terminal double bond content detected at 5.7 to 6.3 ppm, the content of terminal double bonds detected at 5.7 to 6.3 ppm from the ones originating from the modified portion in the modified polyolefin may be obtained.

From the NMR analysis results, peaks of methyl groups detected at 0.0 to 0.4 ppm are characteristic peaks of a modified polyolefin, and the number of methyl groups was obtained by quantifying the peaks in that portion.

[Table 4]

|  | Peaks originating from modified portion in modified polyolefin | |
|---|---|---|
|  | No. of terminal double bonds detected at 5.7-6.3 ppm (per 1000C) | No. of methyl groups detected at 0.0-0.4 ppm (per 1000C) |
| Example 1 | 0.307 | 3.613 |
| Example 2 | 0.826 | 10.787 |

(continued)

| | Peaks originating from modified portion in modified polyolefin | |
|---|---|---|
| | No. of terminal double bonds detected at 5.7-6.3 ppm (per 1000C) | No. of methyl groups detected at 0.0-0.4 ppm (per 1000C) |
| Example 3 | 0.095 | 1.463 |
| Example 4 | 0.246 | 3.549 |
| Example 5 | 0.434 | 0.983 |
| Example 6 | 0.347 | 1.127 |
| Example 7 | 0.176 | 0 |
| Example 8 | 0.255 | 0.985 |
| Example 9 | 0.005 | 0.073 |
| Example 10 | 0.029 | 0.439 |
| Example 11 | 0.048 | 0.732 |
| Example 12 | 0.022 | 0.049 |
| Example 13 | 0.130 | 0.295 |
| Example 14 | 0.217 | 0.492 |
| Comparative Example 1 | - | - |
| Comparative Example 2 | 0 | 0 |

As shown in Table 4, it was determined that although the degree of grafting during a reaction extrusion process varied depending on each reagent and the amount of reagent, terminal double bonds were detected in a certain range (detected at 5.7 to 6.3 ppm) in the polyolefin compositions of Examples 1 to 8 of the present invention using silane compounds containing two or more vinyl groups as reagents. In addition, it was determined that terminal double bonds were detected (detected at 5.7 to 6.3 ppm) in the polyolefin compositions of Examples 9 to 14 of the present invention, which partially contained modified polyolefins prepared using such silane compounds, although the amount was slightly lower than that of Examples 1 to 8.

In the case of Comparative Example 2, a modified polyolefin was prepared by grafting a silane compound, but the silane compound used contained one vinyl group, and thus it was determined that no terminal double bonds were detected at 5.7 to 6.3 ppm of peaks originating from a modified portion in a modified polyolefin in the NMR measurement, as the double bonds of the vinyl group were broken, resulting in bonding to a polyolefin main chain when preparing a modified polyolefin.

**Experimental Example 3**

Using the encapsulant films of Examples 1 to 14 and Comparative Examples 1 and 2, crosslinked sheets were manufactured through the following method, and then the crosslinking properties of the crosslinked sheets were measured through the following method, and analysis results are shown in Table 5.

An encapsulant film (10 cm X 10 cm) having a thickness of 0.5 mm was placed between two release films (thickness: about 100 um), and crosslinked by laminating in a vacuum laminator at a process temperature of 145°C for a process time of 20 minutes (5 minutes of vacuum/1 minute of pressurization/14 minutes of continuous pressure).

1) Crosslinking degree

The crosslinked sheet was cut into $3 \times 3$ mm$^2$ using scissors. The sides and bottom of a 120-mesh screen of $7 \times 14$ cm$^2$ were stapled. The sheet was placed in the screen, and the weight of the sheet was measured. The amount of sheet was set to 0.49 to 0.51 g. After placing the sheet, the top of the screen was stapled, and the total weight of the sample was measured. A solution in which 10 g of dibutylhydroxytoluene (BHT) was dissolved in 1,000 g of xylene was poured into a 2 L cylinder reactor, and 3 to 4 of the above samples were added. The reactor was heated, and the reflux was terminated after 5 hours from the time when boiling began. The sample in the reactor was taken out using a metal scoop net and vacuum dried at 140°C for 24 hours. The weight of the dried sample was measured and the degree of crosslinking was calculated using the following Mathematical Equation 1. The degree of crosslinking may be determined as an average value of 3 to 4 samples refluxed in xylene.

Crosslinking degree (%) = [(Weight of sheet after reflux) / (Weight of sheet before reflux)] x 100                    [Mathematical Equation 1]

2) Light transmittance (%)

Light transmittance in a visible light range of the crosslinked sheet (380 to 1,000 nm) was measured using a Shimadzu UV-3600 spectrophotometer (measurement mode: transmittance, wavelength interval: 1 nm, measurement speed: medium).

3) Volume resistivity ($\Omega \cdot$ cm)

Tests were performed at room temperature based on ASTM D257. The crosslinked sheet was placed in a Keithley 8009 Resistivity test fixture and subjected to a voltage of 1,000 V using a 6517B Electrometer/High Resistance meter to measure volume resistivity.

[Table 5]

| | Crosslinking degree (%) | Light transmittance (%) | | Volume resistivity ($\Omega \cdot$ cm) |
|---|---|---|---|---|
| | | 550 nm | Vis | |
| Example 1 | 81.9 | 93.0 | 92.5 | 4.2E+16 |
| Example 2 | 83.8 | 92.0 | 92.1 | 2.1E+16 |
| Example 3 | 81.1 | 92.2 | 92.3 | 5.7E+16 |
| Example 4 | 80.2 | 92.1 | 92.4 | 4.9E+16 |
| Example 5 | 85.2 | 92.5 | 92.7 | 1.1E+17 |
| Example 6 | 90.5 | 92.0 | 92.2 | 1.3E+17 |
| Example 7 | 78.4 | 92.3 | 92.5 | 4.7E+16 |
| Example 8 | 75.0 | 92.7 | 92.5 | 3.5E+16 |
| Example 9 | 74.7 | 92.5 | 92.4 | 5.5E+16 |
| Example 10 | 78.6 | 92.2 | 92.1 | 5.7E+16 |
| Example 11 | 80.0 | 92.3 | 92.5 | 5.4E+16 |
| Example 12 | 75.0 | 92.2 | 92.3 | 6.8E+16 |
| Example 13 | 80.4 | 92.3 | 92.1 | 7.1E+16 |
| Example 14 | 83.0 | 92.4 | 92.5 | 7.3E+16 |
| Comparative Example 1 | 73.1 | 92.0 | 92.2 | 6.1E+16 |
| Comparative Example 2 | 73.8 | 92.3 | 92.5 | 3.0E+16 |

As shown in Table 5, it was determined that Examples 1 to 14 containing terminal double bonds, i.e., vinyl silane groups, in the polyolefin composition, exhibited the light transmittance and volume resistivity similar or equivalent to those of Comparative Examples, but had a significantly increased degree of crosslinking.

It was determined that Comparative Example 2 exhibited a slight improvement in the degree of crosslinking compared to Comparative Example 1, which used a copolymer that was not modified using a reagent. However, the silane compound used in Comparative Example 2 is a reagent commonly used in the preparation of graft polyolefin, and since the compound itself contains one vinyl group, an increase in terminal double bonds due to modified polyolefin in the polyolefin after grafting did not take place, thereby showing a significantly lower degree of crosslinking compared to Examples of the present invention.

**Claims**

1. A polyolefin composition comprising a modified polyolefin containing a vinyl silane group.

2. The polyolefin composition according to claim 1, comprising terminal double bonds at a content of 0.001 to 1 per 1,000 total carbon atoms, as detected at 5.7 to 6.3 ppm of peaks originating from a modified portion in the modified polyolefin, when the modified polyolefin is immersed in acetone at 60°C for 12 hours, washed, and subsequently dissolved in a TCE-d$_2$ solvent, and then subjected to $^1$H NMR (373K) analysis.

3. The polyolefin composition according to claim 1, wherein the vinyl silane group is derived from a silane compound containing two or more vinyl groups.

4. The polyolefin composition according to claim 3, wherein the silane compound is selected from the group consisting of tris(vinyldimethylsiloxy)methylsilane, tris(vinyldimethylsiloxy)phenylsilane, 1,3,5-trivinyl-1,1,3,5,5-pentamethyltrisiloxane, 2,4,6-trimethyl-2,4,6-trivinylcyclotrisiloxane, tetravinylsilane, and 1,3-divinyltetramethyldisiloxane.

5. The polyolefin composition according to claim 1, wherein the polyolefin is a copolymer of ethylene and an alpha-olefin comonomer.

6. The polyolefin composition according to claim 5, wherein the alpha-olefin comonomer is an alpha-olefin comonomer of 3 to 12 carbon atoms.

7. The polyolefin composition according to claim 6, wherein the alpha-olefin comonomer comprises at least one selected from the group consisting of 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alphamethylstyrene, divinylbenzene, and 3-chloromethylstyrene.

8. A composition for an encapsulant film comprising the polyolefin composition according to any one of claims 1 to 7.

9. An encapsulant film formed using the composition for an encapsulant film of claim 8.

10. A solar cell module comprising the encapsulant film of claim 9.

## INTERNATIONAL SEARCH REPORT

| International application No. |
|---|
| **PCT/KR2024/019550** |

| | |
|---|---|
| **A.** | **CLASSIFICATION OF SUBJECT MATTER** |
| | **C08F 255/02**(2006.01)i; **C08F 230/08**(2006.01)i; **C08F 210/16**(2006.01)i; **C08L 51/06**(2006.01)i; **C08J 5/18**(2006.01)i; **H10F 19/80**(2025.01)i |
| | According to International Patent Classification (IPC) or to both national classification and IPC |

| | |
|---|---|
| **B.** | **FIELDS SEARCHED** |
| | Minimum documentation searched (classification system followed by classification symbols) |
| | C08F 255/02(2006.01); B60J 10/17(2016.01); C08F 255/00(2006.01); C08F 255/04(2006.01); C08K 5/13(2006.01); C08L 23/00(2006.01); C08L 23/12(2006.01); C08L 23/16(2006.01); C08L 83/14(2006.01); C09J 151/04(2006.01); C09J 151/06(2006.01); C09J 7/10(2018.01); C09J 7/30(2018.01); C09J 7/35(2018.01) |
| | Documentation searched other than minimum documentation to the extent that such documents are included in the fields searched |
| | Korean utility models and applications for utility models: IPC as above<br>Japanese utility models and applications for utility models: IPC as above |
| | Electronic data base consulted during the international search (name of data base and, where practicable, search terms used) |
| | eKOMPASS (KIPO internal) & keywords: 바이닐 실란기(vinyl silane), 변성 폴리올레핀(modified polyolefin), 봉지재 (encapsulant), 태양전지 모듈(solar cell module) |

**C.** **DOCUMENTS CONSIDERED TO BE RELEVANT**

| Category* | Citation of document, with indication, where appropriate, of the relevant passages | Relevant to claim No. |
|---|---|---|
| X<br><br>Y | CN 114921026 A (SHAANXI YANCHANG JINGWEI NEW MATERIAL TECHNOLOGY INDUSTRIAL PARK CO., LTD.) 19 August 2022 (2022-08-19)<br>claims 1, 2, 6; paragraph [0018]; example 1 | 1-7<br><br>8-10 |
| Y | KR 10-2468900 B1 (LINTEC CORPORATION) 18 November 2022 (2022-11-18)<br>claims 1, 21, 22; paragraphs [0094], [0095] | 8-10 |
| X | US 6465107 B1 (KELLY, P. Y.) 15 October 2002 (2002-10-15)<br>claims 1, 8, 11; column 6, lines 17-40 | 1,3,5-7 |
| X | US 2019-0185604 A1 (COOPER-STANDARD AUTOMOTIVE, INC.) 20 June 2019 (2019-06-20)<br>abstract; claims 1, 4; paragraphs [0041], [0056] | 1,3,5-7 |

| ✓ | Further documents are listed in the continuation of Box C. | | ✓ | See patent family annex. |
|---|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 March 2025** | **05 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 717 717 A1**

**INTERNATIONAL SEARCH REPORT**

| International application No. |
| PCT/KR2024/019550 |

**C.    DOCUMENTS CONSIDERED TO BE RELEVANT**

| Category* | Citation of document, with indication, where appropriate, of the relevant passages | Relevant to claim No. |
|---|---|---|
| X | EP 1018533 A2 (DUPONT CANADA INC.) 12 July 2000 (2000-07-12)<br>claims 1, 2, 5; paragraphs [0013], [0025], [0026] | 1,3,5-7 |
| X | KR 10-2020-0043422 A (SI GROUP SWITZERLAND (CHAA) GMBH) 27 April 2020 (2020-04-27)<br>abstract; claims 1, 2, 5; paragraph [0032] | 1,3,5-7 |
| A | CN 117777869 A (ZHEJIANG CYBRID APPLICATION TECHNOLOGY CO., LTD.) 29 March 2024 (2024-03-29)<br>claims 1-3; paragraph [0037] | 1-10 |
| A | CN 116023891 A (ANHUI CHUZHOU DEWEI NEW MATERIAL CO., LTD.) 28 April 2023 (2023-04-28)<br>claims 1-10 | 1-10 |

Form PCT/ISA/210 (second sheet) (July 2022)

## INTERNATIONAL SEARCH REPORT
### Information on patent family members

International application No.

**PCT/KR2024/019550**

| Patent document cited in search report | | | Publication date (day/month/year) | Patent family member(s) | | | Publication date (day/month/year) |
|---|---|---|---|---|---|---|---|
| CN | 114921026 | A | 19 August 2022 | CN | 114921026 | B | 22 March 2024 |
| KR | 10-2468900 | B1 | 18 November 2022 | CN | 110709485 | A | 17 January 2020 |
| | | | | CN | 110709485 | B | 28 June 2022 |
| | | | | JP | 6590451 | B2 | 16 October 2019 |
| | | | | TW | 201903099 | A | 16 January 2019 |
| | | | | TW | I776903 | B | 11 September 2022 |
| | | | | WO | 2018-221510 | A1 | 06 December 2018 |
| US | 6465107 | B1 | 15 October 2002 | AU | 4196597 | A | 02 April 1998 |
| | | | | CA | 2265868 | A1 | 19 March 1998 |
| | | | | WO | 98-10724 | A1 | 19 March 1998 |
| US | 2019-0185604 | A1 | 20 June 2019 | US | 10040888 | B1 | 07 August 2018 |
| | | | | US | 10253127 | B2 | 09 April 2019 |
| | | | | US | 10774168 | B2 | 15 September 2020 |
| | | | | US | 2018-0223025 | A1 | 09 August 2018 |
| | | | | US | 2018-0258208 | A1 | 13 September 2018 |
| | | | | US | 2019-0031805 | A1 | 31 January 2019 |
| | | | | US | 2019-0202957 | A1 | 04 July 2019 |
| EP | 1018533 | A2 | 12 July 2000 | CA | 2291316 | A1 | 08 July 2000 |
| | | | | DE | 60024505 | T2 | 17 August 2006 |
| | | | | EP | 1018533 | A3 | 04 July 2001 |
| | | | | EP | 1018533 | B1 | 07 December 2005 |
| KR | 10-2020-0043422 | A | 27 April 2020 | BR | 112020003290 | A2 | 01 September 2020 |
| | | | | CN | 110998752 | A | 10 April 2020 |
| | | | | CN | 110998752 | B | 27 October 2023 |
| | | | | EP | 3669382 | A1 | 24 June 2020 |
| | | | | EP | 3669382 | B1 | 01 January 2025 |
| | | | | GB | 2565587 | A | 20 February 2019 |
| | | | | JP | 2020-531604 | A | 05 November 2020 |
| | | | | US | 11795257 | B2 | 24 October 2023 |
| | | | | US | 2020-0362081 | A1 | 19 November 2020 |
| | | | | WO | 2019-034665 | A1 | 21 February 2019 |
| CN | 117777869 | A | 29 March 2024 | None | | | |
| CN | 116023891 | A | 28 April 2023 | CN | 116023891 | B | 08 November 2024 |

Form PCT/ISA/210 (patent family annex) (July 2022)

**EP 4 717 717 A1**

**Patent documents cited in the description**

- KR 1020240071568